Europäisches Patentamt

**European Patent Office**

Office européen des brevets

(11) Publication number: **0 117 339**
**B1**

(12) **EUROPEAN PATENT SPECIFICATION**

(45) Date of publication of patent specification: **11.03.87**

(21) Application number: **83306681.4**

(22) Date of filing: **02.11.83**

(51) Int. Cl.⁴: **H 01 L 27/08**

(54) Stacked MOS transistor.

(30) Priority: **09.11.82 CA 415233**

(43) Date of publication of application:
**05.09.84 Bulletin 84/36**

(45) Publication of the grant of the patent:
**11.03.87 Bulletin 87/11**

(84) Designated Contracting States:
**AT CH DE FR GB LI NL SE**

(56) References cited:
**IEEE ELECTRON DEVICE LETTERS, vol. EDL-2,
no. 10, October 1981, New York J.P. COLINGE
et al. "A high density CMOS inverter with
stacked transistors", pages 250-251**

(73) Proprietor: **NORTHERN TELECOM LIMITED
1600 Dorchester Boulevard West
Montreal Quebec H3H 1R1 (CA)**

(72) Inventor: **Naem, Abdalla Aly
201 Bell Street North, Apt. 916A
Ottawa Ontario K1R 7E2 (CA)**
Inventor: **Calder, Iain Douglas
27 Cleadon Drive
Nepean Canada, K2H 5P4 (CA)**
Inventor: **Boothroyd, Albert Roy
13 Erinlea Court
Nepean Ontario K2E 7C8 (CA)**
Inventor: **Naguib, Hussein Mostafa
6 Beaufort Drive
Kanata Ontario, K2L 1Z4 (CA)**

(74) Representative: **Crawford, Andrew Birkby et al
A.A. THORNTON & CO. Northumberland House
303-306 High Holborn
London WC1V 7LE (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to metal-oxide-semiconductor (MOS) transistors and to a method for making them.

In the design of new very large scale integrated (VLSI) circuits, attempts have been made to reduce the device area by scaling the structural and electrical parameters in proportion. However, there are limitations imposed by this approach on device performance and technology, as described by Hoeneisen and Mead, in Solid State Electronics, Volume 15, pages 819—829, 1972.

Recently, vertical integration of devices has been proposed as an alternative to scaling down device area to achieve higher packing density. This technique has, for example, been applied to CMOS inverters. Stacked CMOS inverters having a common gate for both n- and p-channel transistors have been described by Gibbons et al, IEEE Electron Device Letters, EDL-1, page 11 et seq, and by Goeloe et al, IEDM, Washington, D.C., page 544 et seq, 1981. Also a CMOS inverter more conductive to standard silicon integrated circuit fabrication techniques has been suggested by Colinge et al, IEEE Electron Device Letters, EDL-2, pages 250 et seq, 1981. The n- and p-type transistors making up the inverter are stacked one on top of the other and have a common gate and a common drain. The top part of the drain is laser annealed polysilicon which is essentially integral with a bottom part of the drain formed within the silicon substrate.

According to one aspect of the invention there is provided a metal-oxide-semiconductor structure having a gate, a source, a drain and a channel extending between the source and drain, the channel being separated from the gate by an insulating layer wherein each of the source, the drain and the channel have a lower part formed in a silicon substrate and an upper part composed of recrystallized polysilicon, the gate being located between the upper and lower channel parts.

In a preferred form of the device, the insulating layer is silicon dioxide and the gate consists of recrystallized polysilicon. In effect, the recrystallized polysilicon in which part of the source, the channel and the drain are located functions as a second silicon substrate which shares the device channel duty with the part of the channel formed within the silicon substrate.

To achieve further vertical integration appropriate oxide and polysilicon layers can be grown or deposited to form a transistor which has a common source and drain and several possible channel routes between them. Preferably the crystal orientation of the source, drain and channel regions formed within the recrystallized polysilicon is such as to form an essentially epitaxial continuation of the underlying source and drain regions within the substrate.

The Colinge et al stacked CMOS inverter mentioned previously comprises a pair of independent transistors which share a common drain and a common gate but have their sources isolated from one another. The stacked metal-oxide-semiconductor (SMOS) device now proposed is essentially a single transistor. By adopting a stacking technique, the device channel is vertically distributed so that the effective device area is halved. Device performance is improved when the channel regions are made narrow as well as short, as described by Naem in Electronic Letters, pages 135—136, February 1982.

According to another of the invention there is provided in a method of fabricating a stacked metal-oxide-semiconductor structure the steps of forming a first source region and a first drain region in a silicon substrate, forming a recrystallized polysilicon gate within an oxide layer overlying a channel region extending between the source and drain regions, subsequently forming thereon a recrystallized polysilicon layer, and forming in the recrystallized polysilicon layer a second source region and a second drain region with the two source regions in contact and the two drain regions in contact.

Preferably the recrystallized polysilicon in the source and drain regions extends to bonding pads. This eliminates the need for source and drain contact windows which provides an additional degree of freedom to the device designer.

The method preferably includes the following additional steps. All polysilicon is deposited by low pressure chemical vapour deposition. The polysilicon gate is defined and then recrystallized by laser annealing. The laser annealing step can also function to drive dopant into the gate and the first source and drain regions. The gate oxide within which the gate is formed is thermally grown in a two-stage process as a first layer before gate formation and a second layer after it. The gate oxide is etched through to the first source and drain regions before deposition of the top polysilicon layer. The polysilicon layer is doped by ion implantation to provide an active top layer substrate and is recrystallized by laser annealing after deposition of an anti-reflective nitride coating on the polysilicon layer to cover the source, drain, the top channel region and interconnects to bonding pads. Because the region of the polysilicon layer overlying the gate is thermally insulated from the substrate by two oxide layers and the gate itself, it is rendered several degrees hotter than the polysilicon overlying the drain and source regions. Therefore, upon cooling, it solidifies after recrystallization of the polysilicon overlying the source and drain regions. Consequently, crystal growth occurs first from the drain and source regions in the substrate by seeding of the adjacent polysilicon and finally reaches the polysilicon over the gate. Subsequently, using standard etching and photolithographic techniques, the anti-reflective coating is removed and the second source and drain regions are formed, for example, by dopant predeposition and drive-in.

Embodiments of the invention will now be described by way of example with reference to the accompanying drawings in which:—

Figure 1 is a sectional view showing a SMOS transistor according to the invention;

Figures 2(a) to 2(h) show successive stages in the preparation of the Figure 1 transistor using a fabrication technique according to the invention;

Figure 3 is a schematic plan view of superimposed masks used in fabricating the Figure 1 transistor; and

Figures 4(a) and 4(b) shows schematically and in cross-section alternative transistor structures obtainable using the method of the invention.

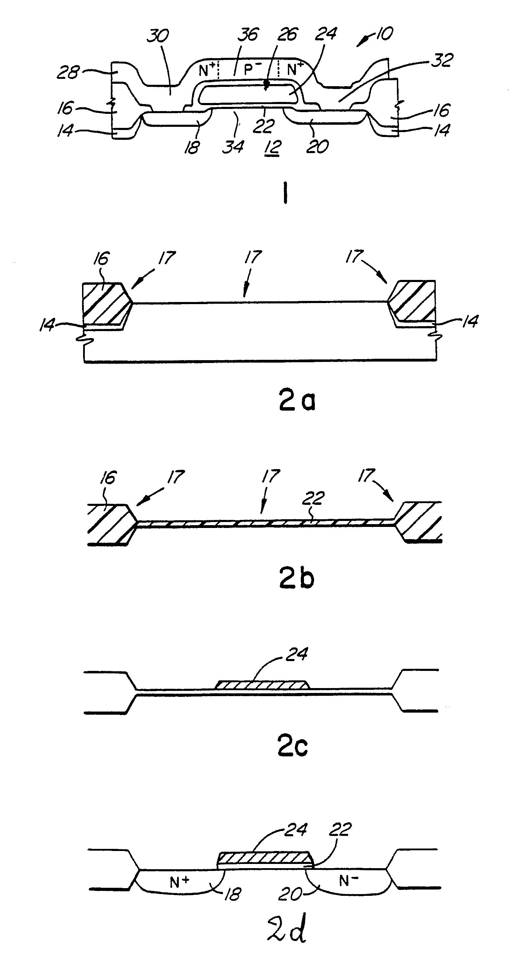

Referring to Figure 1, the stacked metal-oxide-semiconductor (SMOS) transistor 10 formed on a silicon substrate has a p-type substrate 12 and p+-type regions 14 underlying $SiO_2$ isolating field oxide regions 16. Witin the substrate are n+-type source and drain regions 18 and 20 respectively. Extending between the source and drain regions and overlying the substrate is a first gate oxide layer 22. Over the gate oxide layer is a recrystallized polysilicon gate 24 and a second gate oxide layer 26. Overlaying the whole structure is a recrystallized polysilicon layer 28 which is appropriately doped to give source and drain regions 30 and 32 which respectively contact the source and drain regions 18 and 20 in the silicon substrate. Between the source and drain regions at respective levels are n-type channel regions 34 and 36.

The Figure 1 device is an n-channel enhancement mode transistor. In operation, a voltage applied to the common gate 26 induces an electric field within regions 34 and 36. When the gate voltage is of proper polarity and magnitude a localized inversion layer is formed both above and below the gate to render the upper and lower channel regions 34 and 36 conducting.

The Figure 1 transistor has two spaced channel regions 34, 36 but there is no reason why in principle the transistor should not have more than two vertically spaced channels if several vertical layers are desired.

Having specifically described the Figure 1 structure a preferred method for fabricating it is now described.

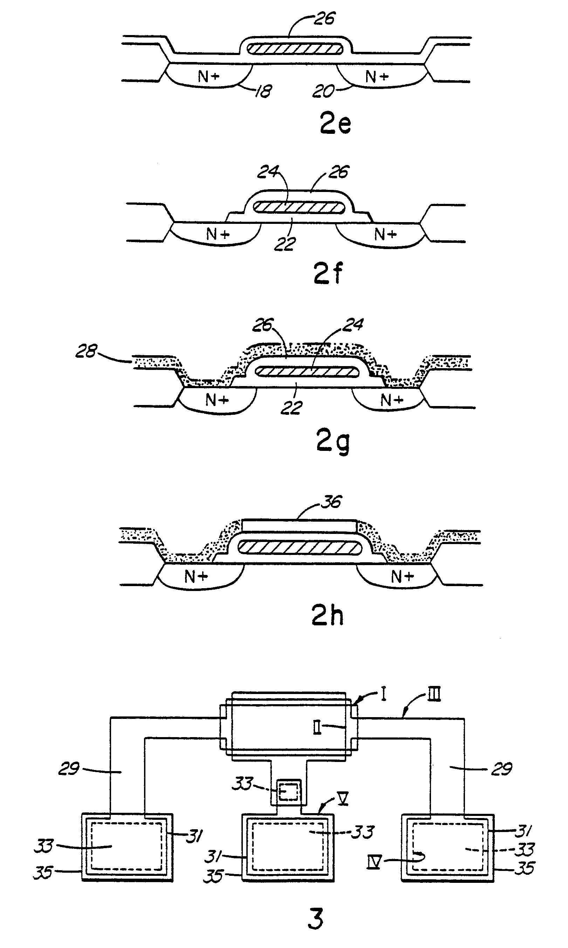

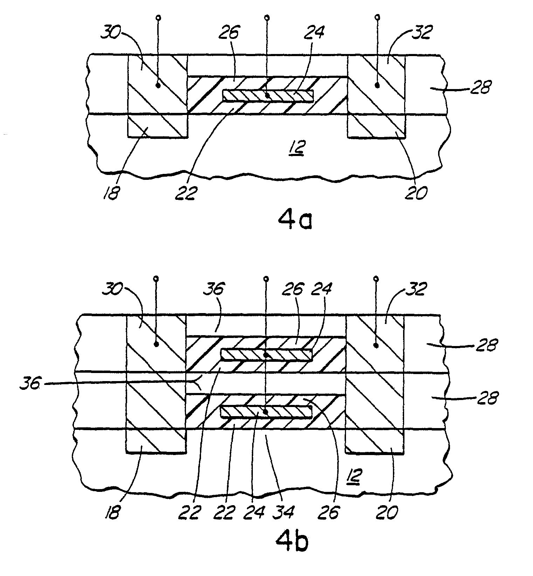

Referring to Figure 2(a), on a p-type silicon substrate, field oxide 16 is grown using a known LOCOS technique and a mask I (Figure 3) to define a device well 17. Boron is ion-implanted under the field oxide regions 16 and a first gate oxide layer 22 is thermally grown (Figure 2(b)).

Referring to Figure 2(c), using a Mask II (Figure 3) a 7,500Å polysilicon layer is low pressure chemically vapour deposited at 625°C and then patterned to produce a common gate region 24.

Referring to Figure 2(d), standard techniques are used to define the gate oxide 22 and at the same time to define the source and drain regions within the substrate and a phosphorus predeposition and drive-in technique is used to obtain n+-type doping in these regions 18, 20. The polysilicon at the gate region is then recrystallized in a laser annealing step using an argon laser with a power output of about 6 watts, beam diameter of 50 microns and a scan rate of 50 centimeters/ second. With these conditions the polysilicon is converted into large grains. The laser annealing step can in fact be used to drive the pre-deposited phosphorus impurities into the gate, source and drain regions.

Referring to Figure 2(e) a 1,000Å layer of top gate oxide is thermally grown at 1,050°C in dry oxygen and, using standard techniques the gate oxide 26 is selectively etched to expose the n+-type source and drain regions 18 and 20 (Figure 2(f)).

Referring to Figure 2(g), a 7,500Å polysilicon layer 28 is low-pressure chemically vapour deposited at 625°C. The layer is then patterned using the Mask III (Figure 3).

The polysilicon is implanted with boron using a dosage of $5 \times 10^{11}/cm^2$ at 60 kev to form an active p-type top layer substrate for the upper channel 36 of the Figure 1 transistor. A 600Å layer of silicon nitride is then low-pressure chemically vapour deposited at 650°C and is defined so as to cover both the device well which extends between the field oxide regions 16, and interconnect regions 29 which extend from the source and drain to bonding pads. The layer functions as an anti-reflective coating during a subsequent selective laser annealing step using an argon laser with the previously recited operating conditions. The presence of the nitride layer ensures that the underlying polysilicon is melted during laser annealing. The polysilicon overlying the gate 24 since it is thermally insulated from the substrate is hotter than that overlying the source and drain regions and consequently cools and recrystallizes later. The substrate source and drain regions 18, 20 therefore function to seed crystal growth within the polysilicon layer 28, the crystal formation propagating away from the source and drain into the channel region 36 overlying the gate 24.

The anti-reflective coating is subsequently removed by etching. Using Mask II (Figure 3) the phosphorus pre-deposition and drive-in technique is used to render the regions of the recrystallized polysilicon overlying the substrate source and drain regions n+-type. In effect, additional source and drain regions 30, 32 are formed in the polysilicon 28, these being integral with the source and drain regions 18, 20 in the substrate.

As is evident from Figure 3 the top polysilicon layer 28 is patterned to provide lead regions 29. The regions are subjected to annealing, dopant pre-deposition and drive-in processes so that they become highly conducting. Subsequently, using Mask IV, contact windows 33 are opened to the regions 29 and aluminum pads 35 are chemically vapor deposited to contact polysilicon areas 31. The device is processed to completion using well known integrated circuit fabrication techniques.

Finally, referring to Figure 4 there are shown schematically sectional views of transistors produced using the method previously described. Figure 4(a) shows the transistor described in detail with respect to Figures 1 to 3, the transistor having a channel vertically divided into two channel regions. In Figure 4(b), there is shown a single transistor produced using an iteration of the method, the transistor having a channel vertically divided into four channel regions 34, 36.

## Claims

1. A metal-oxide-semiconductor structure having a gate, a source, a drain and a channel extending between the source and drain, the channel being separated from the gate by an insulating layer characterized in that each of the source, the drain and the channel have a lower part (18, 20, 34) formed in a silicon substrate (12) and an upper part (30, 32, 36) composed of recrystallized polysilicon, the gate (24) being located between the upper and lower channel parts.

2. A metal-oxide-semiconductor structure as claimed in claim 1 further characterized in that the insulating layer (22, 26) is thermally grown silicon dioxide.

3. A metal-oxide-semiconductor structure as claimed in claim 1 further characterized in that the gate (24) is laser recrystallized polysilicon.

4. A metal-oxide-semiconductor structure as claimed in claim 1 further characterized in that the recrystallized polysilicon forming upper parts (30, 32, 36) of the source, the drain and the channel has a crystal orientation forming an essentially epitaxial continuation of the lower underlying source and drain regions (18, 20) within the substrate.

5. A method of fabricating a metal-oxide-semiconductor structure comprising the steps of forming a first source region and a first drain region in a silicon substrate, forming a recrystallized polysilicon gate within a oxide layer overlying a channel region extending between the source and drain regions, subsequently forming thereon a recrystallized polysilicon layer, the method characterized by forming in the recrystallized polysilicon layer (28) a second source region (18) and a second drain region (20) with the two source regions (18) in contact and the two drain regions in contact.

6. A method as claimed in claim 5 further characterized in that the gate (24) and layer (28) of polysilicon are low pressure chemically vapour deposited.

7. A method as claimed in claim 5 further characterized in that the polysilicon layer (28) is recrystallized by laser annealing.

8. A method as claimed in claim 7 further characterized in that the recrystallized polysilicon layer (28) is doped to provide an active top layer substrate.

9. A method as claimed in claim 8 further characterized in that the recrystallized polysilicon layer (28) is doped by ion implantation.

10. A method as claimed in claim 7 further characterized in that an anti-reflective nitride coating is deposited on the polysilicon layer to cover intended source, drain and common gate regions preparatory to laser annealing.

11. A method as claimed in claim 10 further characterized in that the laser annealing step is used to also to form within the polysilicon layer (28), recrystallized polysilicon regions to function as leads (29) from the source and drain to sites of bonding pads (35).

12. A method as claimed in claim 10 further characterized in that following laser annealing of the polysilicon layer (28), the anti-reflective coating is removed and selective areas of the recrystallized layer a doped to function as second source and drain regions (30, 32).

13. A method as claimed in claim 12 further characterized in that the second source and drain regions are doped by dopant pre-deposition and drive-in.

14. A method as claimed in claim 7 further characterized in that the gate (24) is also formed by laser annealed recrystallization of polysilicon.

15. A method as claimed in claim 5 further characterized in that the oxide layer is thermally grown as a first layer (22), before formation of the gate, and a second overlying layer (26) after formation of the gate.

16. A method as claimed in claim 15 further characterized in that the gate oxide is etched through to the first source and drain regions (18, 20) before deposition of the polysilicon layer (28).

17. A method as claimed in claim 6 further characterized in that while forming the recrystallized polysilicon source and drain regions (30, 32), recrystallized polysilicon extensions thereof are simultaneously formed, said extensions (29) extending to sites at which bonding pads (35) are subsequently deposited.

## Patentansprüche

1. Metalloxid-Halbleiter-Struktur mit einem Gate, einer Source, einem Drain und einem sich zwischen Source und Drain erstreckenden Kanal, wobei der Kanal von dem Gate durch eine isolierende Schicht getrennt ist, dadurch gekennzeichnet, daß sowohl die Source, wie der Drain und der Kanal einen unteren, in einem Silizium-substrat (12) ausgebildeten Teil (18, 20, 34) und einen aus rekristallisiertem Polysilizium bestehenden oberen Teil (30, 32, 36) besitzen und das Gate (24) zwischen dem oberen und dem unteren Teil des Kanal angeordnet ist.

2. Metalloxid-Halbleiter-Struktur nach Anspruch 1, weiter dadurch gekennzeichnet, daß die isolierende Schicht (22, 26) thermisch gewachsenes Siliziumdioxid ist.

3. Metalloxid-Halbleiter-Struktur nach Anspruch 1, weiter dadurch gekennzeichnet, daß das Gate (24) durch Laser rekristallisiertes Polysilizium ist.

4. Metalloxid-Halbleiter-Struktur nach Anspruch 1, weiter dadurch gekennzeichnet, daß das dem oberen Teil (30, 32, 36) der Source, des Drains und des Kanals bildende rekristallisierte Polysilizium eine Kristallorientierung besitzt, die im wesentlichen eine epitaxiale Fortsetzung der darunter liegenden Source und Drain-Bereiche (18, 20) im Substrat bildet.

5. Verfahren zur Herstellung einer Metalloxid-Halbleiter-Struktur mit den Schritten des Ausbildens eines ersten Source-Bereiches und eines ersten Drain-Bereiches in einem Siliziumsubstrat, des Ausbildens eines Gates aus rekristallisiertem Polysilizium innerhalb einer Oxidschicht, die einen sich zwischen den Source- und Drain-Bereichen erstreckenden Kanalbereich überdeckt, nach-folgendes Ausbilden einer rekristallisierten Polysiliziumschicht darauf, gekennzeichnet durch Ausbilden eines zweiten Source-Bereiches (18) und eines zweiten Drain-Bereiches (20) in der rekristallisierten Polysiliziumschicht (28), wobei die beiden Source-Bereiche (18) und die beiden Drain-Bereiche (20) jeweils miteinander in Berührung sind.

6. Verfahren nach Anspruch 5, weiter dadurch gekennzeichnet, daß das Gate (24) und die Schicht (28) aus Polysilizium chemisch aus Dampf bei niedrigem Druck abgeschieden sind.

7. Verfahren nach Anspruch 5, weiter dadurch gekennzeichnet, daß die Polysiliziumschicht (28) durch Laser-Anlassen rekristallisiert ist.

8. Verfahren nach Anspruch 7, weiter dadurch gekennzeichnet, daß die rekristallisierte Polysiliziumschicht (28) zur Schaffung eines aktiven Oberschicht-Substrates dotiert ist.

9. Verfahren nach Anspruch 8, weiter dadurch gekennzeichnet, daß die rekristallisierte Polysiliziumschicht (28) durch Ionen-Implantierung dotiert ist.

10. Verfahren nach Anspruch 7, weiter dadurch gekennzeichnet, daß eine anti-reflektive Nitrid-Beschichtung auf der Polysilizium-Schicht abgeschieden wird, um die als Source-, Drain- und gemeinsame Gate-Bereiche beabsichtigten Bereiche vor dem Laser-Anlassen zu überdecken.

11. Verfahren nach Anspruch 10, weiter dadurch gekennzeichnet, daß der Laser-Anlaßschritt auch benutzt wird, um innerhalb der Polysilizium-Schicht (28) als Leitungen (29) von der Source und dem Drain zu den Stellen von Anbindungsflecken (35) dienende rekristallisierte Polysilizium-Bereiche zu bilden.

12. Verfahren nach Anspruch 10, weiter dadurch gekennzeichnet, daß nach dem Laser-Anlassen der Polysilizium-Schicht (28) die anti-reflektive Beschichtung entfernt wird und ausgewählte Bereiche der rekristallisierten Schicht dotiert werden,um als zweite Source- und Drain-Bereiche (30, 32) zu dienen.

13. Verfahren nach Anspruch 12, weiter dadurch gekennzeichnet, daß die zweiten Source- und Drain-Bereiche durch Dotierungsmittel-Vorabscheiden und -Eintreiben dotiert werden.

14. Verfahren nach Anspruch 7, weiter dadurch gekennzeichnet, daß das Gate (24) auch durch Laser-Analaß-Rekristallisierung von Polysilizium gebildet wird.

15. Verfahren nach Anspruch 5, weiter dadurch gekennzeichnet, daß die Oxidschicht thermisch als eine erste Schicht (22) vor der Bildung des Gates und eine zweite überdeckende Schicht (26) nach Bildung des Gates thermisch aufgewachsen wird.

16. Verfahren nach Anspruch 15, weiter dadurch gekennzeichnet, daß das Gate-Oxid vor der Abscheidung der Polysilizium-Schicht (28) zu den ersten Source- und Drain-Bereichen (18, 20) durchgeätzt wird.

17. Verfahren nach Anspruch 6, weiter dadurch gekennzeichnet, daß während der Bildung der rekristallisierten Polysilizium-Source- und Drain-Bereiche (30, 32) rekristallisierte Polysilizium- Verlängerungen derselben gleichzeitig gebildet werden, wobei die Verlängerungen (29) sich bis zu Stellen erstrecken, an denen nachfolgend Anbindungsflecken (35) abgeschieden werden.

**Revendications**

1. Structure de semi-conducteur métal-oxyde ayant une grille, une source, un drain et un canal s'étendant entre la source et la drain, le canal étant séparé de la grille par une couche isolante, caractérisée en ce que la source, le drain et le canal ont chacun une partie inférieure (18, 20, 34) formée dans un substrat en silicium (12) et une partie supérieure (30, 32, 36) composée de polysilicium recristallisé, la grille (24) étant située entre les parties supérieure et inférieure du canal.

2. Structure de semi-conducteur métal-oxyde selon la revendication 1, caractérisée en outre en ce que la couche isolante (22, 26) est du bioxyde de silicium ayant subi une croissance thermique.

3. Structure de semi-conducteur métal-oxyde selon la revendication 1, caractérisée en outre en ce que la grille (24) est du polysilicium recristallisé par laser.

4. Structure de semi-conducteur métal-oxyde selon la revendication 1, caractérisée en outre en ce que le polysilicium recristallisé formant les parties supérieures (30, 32, 36) de la source, du drain et du canal a une orientation cristalline constituant une continuation essentiellement épitaxiale des régions inférieures de source et de drain sous-jacentes (18, 20) à l'intérieur du substrat.

5. Procédé de fabrication d'une structure de semi-conducteur métal-oxyde, comprenant les étapes consistant à former une première région de source et une première région de drain dans un substrat de silicium, à former une grille en polysilicium recristallisé à l'intérieur d'une couche d'oxyde surplombant une région de canal s'étendant entre les régions de source et de drain, à former ensuite au-dessus une couche de polysilicium recristallisé, le procédé étant caractérisé par l'étape de formation dans la couche de polysilicium recristallisé (28) d'une seconde région de source (18) et d'une seconde région de drain (20) avec les deux régions de source (18) en contact et les deux régions de drain en contact.

6. Procédé selon la revendication 5, caractérisé en ce que la grille (24) et la couche (28) de polysilicium sont déposées par vapeur chimique à basse pression.

7. Procédé selon la revendication 5, caractérisé en outre en ce que la couche de polysilicium (28) est recristallisée par recuit par laser.

8. Procédé selon la revendication 7, caractérisé en outre en ce que la couche recristallisée de polysilicium (28) est dopée pour fournir un substrat à couche supérieure active.

9. Procédé selon la revendication 8, caractérisé en outre en ce que la couche recristallisée de polysilicium (28) est dopée par implantation ionique.

10. Procédé selon la revendication 7, caractérisé en outre en ce qu'une couche de nitrure antiréfléchissante est déposée sur la couche de polysilicium de manière à recouvrir les régions attendues de source de drain et de grille commune en préparation en vue du recuit par laser.

11. Procédé selon la revendication 10, caractérisé en outre en ce que l'étape de recuit par laser est utilisée également pour former à l'intérieur de la couche de polysilicium (28), les régions de polysilicium recristallisé de manière à fonctionner en fils (29) entre la source et le drain et les emplacements des pastilles de liaison (35).

12. Procédé selon la revendication 10, caractérisé en outre en ce qu'à la suite du recuit par laser de la couche de polysilicium (28), le revêtement anti-réfléchissant est enlevé et des zones sélectives de la couche recristallisée sont dopées pour fonctionner comme secondes régions de source et de drain (30, 32).

13. Procédé selon la revendication 12, caractérisé en outre en ce que les secondes régions de source et de drain sont dopées par pré-dépôt de dopant et pénétration.

14. Procédé selon la revendication 7, caractérisé en outre en ce que la grille (24) est également formée par recristallisation recuite par laser de polysilicium.

15. Procédé selon la revendication 5, caractérisé en outre en ce que la couche d'oxyde subit une croissance thermique à titre de première couche (22), avant la formation de la grille, et de seconde couche de chevauchement (26) après formation de la grille.

16. Procédé selon la revendication 15, caractérisé en outre en ce qu'il y a attaque de la couche de la grille jusqu'aux premières régions de source et de drain (18, 20) avant dépôt de la couche de polysilicium (28).

17. Procédé selon la revendication 6, caractérisé en outre en ce que, alors qu'il y a formation des régions de source et de drain en polysilicium recristallisé (30, 32), des prolongements de celles-ci en polysilicium recristallisé sont simultanément formés, ces prolongements (29) s'étendant jusqu'aux endroits auxquels des pastilles de liaison (35) sont ensuite déposées.

1

2a

2b

2c

2d

26

N+ 18 20 N+

**2e**

24 26

N+ 22 N+

**2f**

26 24

28 N+ 22 N+

**2g**

36

N+ N+

**2h**

I III

II

29 29

33

V

33 31 33 31 33

31 IV 35

35 35

**3**

2

4a

4b